# EUROPEAN PATENT SPECIFICATION

(11) **EP 3 346 510 B1**
(45) Date of publication and mention of the grant of the patent: **17.11.2021**
(21) Application number: 18154218.4
(22) Date of filing: 23.11.2012
(51) Int. Cl.: H01L 33/10, H01L 33/40, H01L 33/46

(54) **SEMICONDUCTOR LIGHT EMITTING DEVICE FOR ULTRAVIOLET LIGHT**
LICHT EMITTIERENDES HALBLEITERBAUELEMENT FÜR ULTRAVIOLETTES LICHT
DISPOSITIF ÉLECTROLUMINESCENT SEMI-CONDUCTEUR DE LUMIÈRE ULTRAVIOLET

(30) Priority: 25.11.2011 KR 20110124452
(43) Date of publication of application: 11.07.2018
(62) Divisional of application: 12193953.2
(73) Proprietor: Suzhou Lekin Semiconductor Co., Ltd., Taicang City, Suzhou (CN)
(72) Inventor: KIM, Jae Hoon, 100-714 SEOUL (KR)
(74) Representative: Plasseraud IP

(56) References cited:
- US-A1- 2004 099 869
- US-A1- 2008 277 681
- US-A1- 2010 123 118
- US-A1- 2011 049 549

## Description

The present application claims priority under 35 U.S.C. § 119(a) of Korean Patent Application No. 10-2011-0124452 filed on November 25, 2011.

### BACKGROUND

The disclosure relates to an ultraviolet semiconductor light emitting device. A light emitting diode (LED) is a semiconductor light emitting device which converts an electric current into light.

Since the semiconductor light emitting device may obtain light having high brightness, semiconductor light emitting device has been widely used for a light source for a display, a light source for a vehicle, and a light source for illumination.

Recently, an ultraviolet semiconductor light emitting device capable of outputting ultraviolet light has been suggested.

However, the ultraviolet light is absorbed inside the ultraviolet semiconductor light emitting device so that quantum efficiency deteriorates.

### SUMMARY

The invention provides an ultraviolet semiconductor light emitting device capable of improving quantum efficiency by preventing ultraviolet light from being absorbed according to appended claim 1.

The invention provides an ultraviolet semiconductor light emitting device capable of improving quantum efficiency by reflecting ultraviolet light forward.

The invention is defined by the ultraviolet light emitting device of appended claim 1.

The ultraviolet semiconductor light emitting device comprises a first conductive semiconductor layer; an active layer (19) under the first conductive semiconductor layer (15); and a second conductive semiconductor layer (21) under the active layer (19), wherein the second conductive semiconductor layer (21) comprises a plurality of patterns (51) to form a protrusion, wherein the plurality of patterns (51) is spaced from each other in a first direction and a second direction crossing the first direction, wherein a distance (B) between the plurality of patterns (51) is larger than a width (A) of the plurality of patterns (51), and width of the patterns (51) reduces in a direction away from the active layer (19), wherein the plurality of patterns (51) reflects an ultraviolet light emitted from the active layer (19), wherein the patterns (51) comprises a plurality of compound semiconductor layers (31a, 31b, 33a, 33b, 35a) comprising at least two semiconductor materials, and wherein the contents of the at least two semiconductor materials are different from each other.

### BRIEF DESCRIPTION OF THE DRAWINGS

FIG. 1 is a sectional view illustrating an ultraviolet semiconductor light emitting device according to a first illustrative embodiment not forming part of the invention;
FIG. 2 is a view illustrating a mechanism reflecting ultraviolet light by the ultraviolet semiconductor light emitting device of FIG.1 not forming part of the present invention;
FIG. 3 is a sectional view illustrating a detailed configuration of a second conductive semiconductor layer of FIG. 1;
FIG. 4 is a sectional view illustrating a flip chip ultraviolet semiconductor light emitting device as one application example of the ultraviolet semiconductor light emitting device of FIG. 1;
FIG. 5 is a sectional view illustrating an ultraviolet semiconductor light emitting device according to a second illustrative embodiment not forming part of the invention;
FIG. 6 is a sectional view illustrating an ultraviolet semiconductor light emitting device according to a third embodiment which forms part of the present invention:
FIG. 7 is a sectional view illustrating a detailed configuration of a second conductive semiconductor layer of FIG. 6;
FIG. 8 is a plan view illustrating a shape of the second conductive semiconductor layer of FIG. 6; and
FIG. 9 is a graph illustrating a reflectance according to wavelength of a second conductive layer of the ultraviolet semiconductor light emitting device according to the first illustrative embodiment not forming part of the invention.

### DETAILED DESCRIPTION OF THE EMBODIMENTS

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings.

Hereinafter, the embodiments will be described with reference to the accompanying drawings. The thickness and size of each layer shown in the drawings may be exaggerated, omitted or schematically drawn for the purpose of convenience or clarity. In addition, the size of elements does not utterly reflect an actual size.

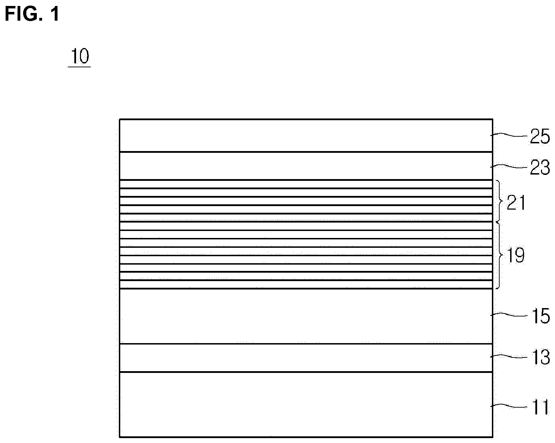

FIG. 1 is a sectional view illustrating an ultraviolet semiconductor light emitting device according to a first embodiment.

Referring to FIG. 1, the an ultraviolet semiconductor light emitting device 10 according to the first embodiment not forming part of the invention may include a substrate 11, a buffer layer 13, a first conductive semiconductor layer 15, an active layer 19, a second conductive semiconductor layer 21, a third conductive semiconductor layer 23, and a fourth conductive semiconductor layer 25.

The first conductive semiconductor layer 15 may function as both of an electrode layer and a barrier layer, the second conductive semiconductor layer 21 may function as a reflective layer, the third conductive semiconductor layer 23 may function as the barrier layer, and the fourth conductive semiconductor layer 25 may function as an electrode layer, but the embodiment is not limited thereto.

The buffer layer 13 and the first to fourth conductive semiconductor layers 25 may include a group III-V compound semiconductor material or a group II-VI compound semiconductor material. For example, the compound semiconductor material may include Al, In, Ga, and N.

The substrate 11 may include a material having superior thermal conductivity and superior light transmittance, but the embodiment is not limited thereto. For example, the substrate 11 may include at least one of sapphire (Al₂O₃), SiC, Si, GaAs, GaN, ZnO, GaP, InP, and Ge, but the embodiment is not limited thereto.

The buffer layer 13 may attenuate lattice mismatch between the substrate 11 and the first conductive semiconductor layer 15.

For example, the buffer layer 13 may include AlN or GaN, but the embodiment is not limited thereto. The buffer layer 13 may have a multi-layer structure in which AlN and GaN are alternately laminated. For example, the buffer layer 13 may have a multi-layer structure in which AlxGaN(0≤x≤1) layers are alternately laminated with different contents of Al.

The first conductive semiconductor layer 15 may be stably grown on the substrate 11 due to the buffer layer 13.

Although not shown, an undoped semiconductor layer may be formed between the buffer layer 13 and the first conductive semiconductor layer 15. The undoped semiconductor layer has no dopants. Since the undoped semiconductor layer has no dopants, the undoped semiconductor layer may have electric conductivity lower than that of the first conductive semiconductor layer 15. For example, the undoped semiconductor layer may include GaN or A1N, but the embodiment is not limited thereto.

The first conductive semiconductor layer 15 may be formed on the buffer layer 13. For example, the first conductive semiconductor layer 15 may be an n type semiconductor layer including an n type dopant. The first conductive semiconductor layer 15 may include a semiconductor material having a composition equation of InxAlyGal-x-yN (0≤x≤1, 0≤y≤1, 0≤x+y≤1), for example, at least one selected from the group consisting of InAlGaN, GaN, AlGaN, InGaN, A1N, InN, and AlInN, but the embodiment is not limited thereto. The n type dopant may include Si, Ge, or Sn.

The first conductive semiconductor layer 15 may function as an electrode layer for supplying a first carrier, that is, electrons to the active layer 19. The first conductive semiconductor layer 15 may function as a barrier layer for preventing a second carrier, that is, holes supplied from the active layer 19 from being transferred to the buffer layer 13.

The first conductive semiconductor layer 15 functions as a barrier layer and another conductive semiconductor layer functioning as an electrode layer may be formed between the buffer layer 13 and the first conductive semiconductor layer 15.

The active layer 19 may be formed on the first conductive semiconductor layer 15.

For example, electrons and holes supplied from the first semiconductor layer 15 and the fourth conductive semiconductor layers 25 may be recombined with each other in the active layer 19, thereby generating an ultraviolet light.

The active layer 19 may have a stack structure of a well layer and a barrier layer including a compound a group III-V or II-VI semiconductor compound having a band gap for generating the ultraviolet light, but the embodiment is not limited thereto.

For example, the active layer 19 may have a stack structure of InGaN/GaN or InGaN/AlGaN. The barrier layer may have a band gap higher than a band gap of the well layer. That is, the active layer 19 may include one of a single quantum well structure, a multi-quantum well structure (MQW), a quantum dot structure, and a quantum wire structure.

The active layer 19 may include one selected from the group consisting of GaN, InGaN, AlGaN, and AlInGaN or may have a periodicity of GaN, InGaN, AlGaN, and AlInGaN.

The second conductive semiconductor layer 21 may be formed on the active layer 19.

The second conductive semiconductor layer 21 may block the ultraviolet light in the active layer 19 to be supplied to the fourth conductive semiconductor layer 25 and reflect the ultraviolet light. For example, the fourth conductive semiconductor layer 25 may include GaN to function as an electrode layer.

The GaN has a characteristic which absorbs the ultraviolet light. Accordingly, when the ultraviolet light of the active layer 19 is supplied to the fourth conductive semiconductor layer 25, the ultraviolet light is absorbed by the fourth conductive semiconductor layer 25 not to be outputted to the outside so that external quantum efficiency may be remarkably deteriorated.

In the first embodiment, since the second conductive semiconductor layer 21 functioning as a reflective layer is formed between the active layer 19 and the fourth conductive semiconductor layer 25, the ultraviolet light from the active layer 19 is reflected from the second conductive semiconductor layer 21 so that external quantum efficiency may be maximized.

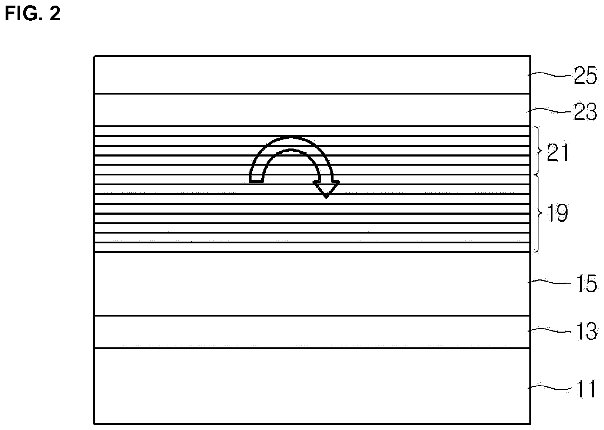

As shown in FIG. 2, the ultraviolet light may be generated from the active layer 19.

The ultraviolet light may be travelled in all directions. Accordingly, the ultraviolet light may be partially travelled to the fourth conductive semiconductor layer 25.

However, the ultraviolet light may be reflected by the second conductive semiconductor layer 21 formed between the active layer 19 and the fourth conductive semiconductor layer 25 such that the ultraviolet light may be travelled to the first conductive semiconductor layer 15 or in a lateral direction.

Accordingly, the ultraviolet light of the active layer 19 is not travelled to the fourth conductive semiconductor layer 25 but reflected to a direction of the first conductive semiconductor layer 15 or in a lateral direction, so that external quantum efficiency may be improved.

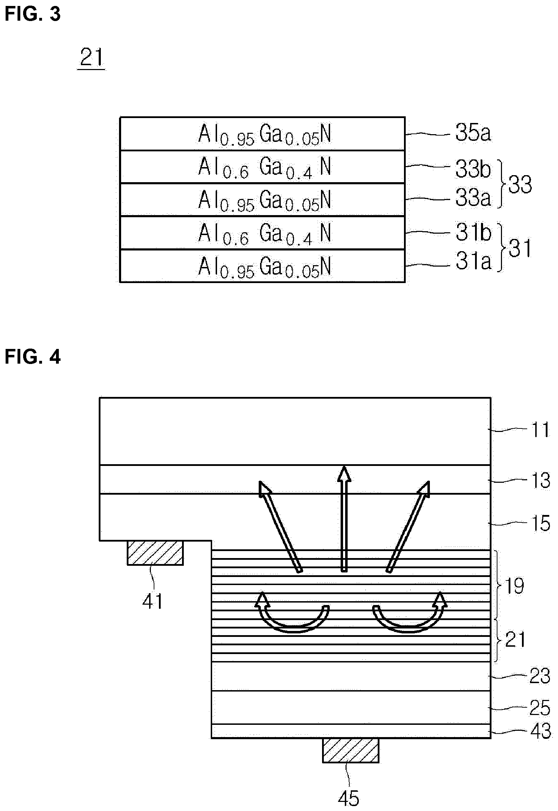

As shown in FIG. 3, the second conductive semiconductor layer 21 may include a plurality of compound semiconductor layers. The second conductive semiconductor layer 21 may have a stack structure of first layers 31a, 33a, and 35a and second layers 31b and 33b.

The number of the first layers 31a, 33a, and 35a and second layers 31b and 33b is odd, but the embodiment is not limited thereto.

The first layers 31a, 33a, and 35a may be defined as odd-numbered layers and the second layers 31b and 33b may be defined as even-numbered layers, respectively, but the embodiment is not limited thereto.

For example, the first layer 31a may be formed as a lowermost layer being in contact with the active layer 19, the second layer 31b may be formed on the first layer 31a, the first layer 33a may be formed on the second layer 31b, the second layer 33b may be formed on the first layer 33a, and the first layer 35a may be formed on the second layer 33b.

For example, the first layer 31a being in contact with the active layer 19 and the second layer 31b on the first layer 31a may be defined as a first pair layer 31. The first and second layers 33a and 33b formed on the first pair layer 31 may be defined as a second pair layer 33.

The second conductive semiconductor layer 21 may include three to five pair layers, but the first embodiment is not limited thereto.

A lowermost layer and an uppermost layer of the second conductive semiconductor layer 21 may have the first layers 31a and 35a in common. That is, a lowermost layer being in contact with the active layer 19 may be configured as the first layer 31a, and an uppermost layer being in contact with the third layer 23 may be configured as the first layer 35a.

The first layers 31a, 33a, and 35a and second layers 31b and 33b may include the same group III-V or II-VI compound semiconductor material. For example, the first layers 31a, 33a, and 35a and second layers 31b and 33b may include AlGaN, but the embodiment is not limited thereto.

However, the first layers 31a, 33a, and 35a and the second layers 31b and 33b may include content of Al different from each other. In addition, the first layers 31a, 33a, and 35a and the second layers 31b and 33b may include content of Ga different from each other.

For example, the content of Al may be higher than the content of Ga in the first layers 31a, 33a, and 35a, and the Al content may be higher than the Ga content in the second layers 31b and 33b, but the embodiment is not limited thereto.

For example, the Al content in the first layers 31a, 33a, and 35a may be higher than that in the second layers 31b and 33b, and the Ga content in the first layers 31a, 33a, and 35a may be lower than that in the second layers 31b and 33b. Through the change of the contents, refractive indexes of the second layers 31b and 33b may be controlled to be higher than those of the first layers 31a, 33a and 35a.

For example, the first layers 31a, 33a, and 35a may include Al content of 95% and Ga content of 5%, whereas the second layers 31b and 33b may include Al content of 60% and Ga content of 40%, but the embodiment is not limited thereto. In this case, the refractive index of the first layers 31a, 33a, and 35a may be 2.1 and the refractive index of the second layers 31b and 33b may be 2.45.

A lowermost layer of the second conductive semiconductor layer 21 and an uppermost layer of the active layer 19 may serve as a barrier layer. In this case, the first layer 31a may be commonly used as the uppermost layer of the active layer 19 and the lowermost layer of the second conductive semiconductor layer 21, and the second layer 31b of the second conductive semiconductor layer 21 may be formed on the first layer 31a.

Meanwhile, the active layer 19 being in contact with the first layers 31a, 33a, and 35a serving as the lowermost layer 21 of the second conductive semiconductor layer 21 has a refractive index higher than a refractive index of the first layer 31a serving as the lowermost layer. The third conductive semiconductor layer 23 being in contact with the first layer 35a serving as the uppermost layer of the second conductive semiconductor layer 21 may has a refractive index higher than a refractive index of the first layer 31a serving as the uppermost layer.

As described above, the second conductive semiconductor layer 21 may function as a reflective layer by laminating the first layers 31a, 33a, and 35a having a low refractive index and the second layers 31b and 33b having a high refractive index.

In the second conductive semiconductor layer 21, each of the first layers 31a, 33a, and 35a may have a thickness larger than that of each of the second layers 31b and 33b, but the embodiment is not limited thereto. The first layers 31a, 33a, and 35a may have a thickness in the range of 30nm to 40nm, and the second layers 31b and 33b may have a thickness in the range of 20nm to 30nm, but the embodiment is not limited thereto.

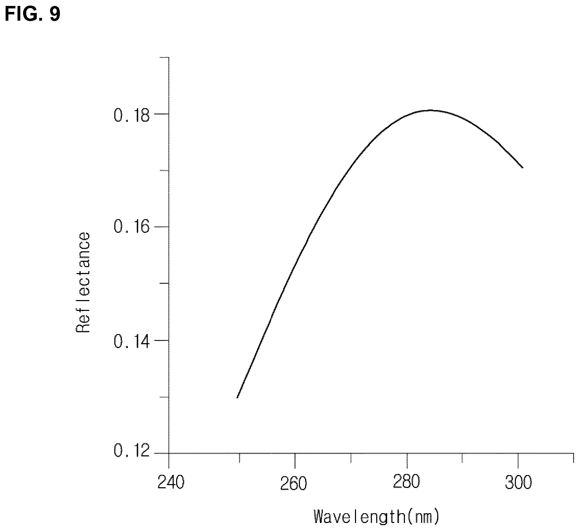

As shown in FIG. 9, a reflectance of the second conductive semiconductor layer 21 may be changed according to wavelength.

The second conductive semiconductor layer 21 of the first embodiment may a maximum reflectance in wavelength in the range of 270nm to 290nm. Accordingly, the active layer 19 of the first embodiment may generate an ultraviolet light having wavelength in the range of 270 nm to 290 nm.

The second conductive semiconductor layer 21 of the first embodiment may mainly reflect the ultraviolet light of wavelength in the range of 270nm to 290nm, but the embodiment is not limited thereto.

That is, the second conductive semiconductor layer 21 may be designed to have a maximum reflectance for the ultraviolet light of wavelength in the range of 270nm to 290nm by changing the contents and thicknesses of the first layers 31a, 33a, and 35a and the second layers 31b and 33b.

Meanwhile, the first layers 31a, 33a, and 35a and the second layers 31b and 33b of the first conductive semiconductor layer 21 may include an n type dopant or a p type dopant.

The first layers 31a, 33a, and 35a and the second layers 31b and 33b of the first conductive semiconductor layer 21 may include no dopants.

One of the first layers 31a, 33a, and 35a and the second layers 31b and 33b of the first conductive semiconductor layer 21 includes an n type dopant or a p type dopant, and the other may not include both of the n type dopant and the p type dopant. For example, the first layers 31a, 33a, and 35a may include the n type dopant and the second layers 31b and 33b may include the p type dopant, but the embodiment is not limited thereto.

A third conductive semiconductor layer 23 functioning as a barrier layer may be formed on the second conductive semiconductor layer 21.

The third conductive semiconductor layer 23 may include a semiconductor material having a composition equation of InxAlyGal-x-yN (0≤x≤1, 0≤y≤1, 0≤x+y≤1), for example, at least one selected from the group consisting of InAlGaN, GaN, AlGaN, InGaN, A1N, InN, and AlInN, but the embodiment is not limited thereto.

For example, the third conductive semiconductor layer 23 may include AlGaN, but the embodiment is not limited thereto. For example, the third conductive semiconductor layer 23 may be a p type semiconductor layer having a p type dopant. The p type dopant may include Mg, Zn, Ca, Sr, or Ba.

A fourth conductive semiconductor layer 25 functioning as an electrode layer may be formed on the third conductive semiconductor layer 23.

The fourth conductive semiconductor layer 25 may include a semiconductor material having a composition equation of InxAlyGal-x-yN (0≤x≤1, 0≤y≤1, 0≤x+y≤1), for example, at least one selected from the group consisting of InAlGaN, GaN, AlGaN, InGaN, A1N, InN, and AlInN, but the embodiment is not limited thereto.

For example, the fourth conductive semiconductor layer 25 may include may be a p type semiconductor layer having a p type dopant. For example, the fourth conductive semiconductor layer 25 may include AlGaN, but the embodiment is not limited thereto. The p type dopant may include Mg, Zn, Ca, Sr, or Ba.

Accordingly, the first conductive semiconductor layer 15 and the fourth conductive semiconductor layer 25 may function as an electrode layer.

For example, the first conductive semiconductor layer 15 may function as an n type electrode layer and the fourth conductive semiconductor layer 25 may function as a p type electrode layer. Accordingly, electrons from the first conductive semiconductor layer 15 may be provide to the active layer 19, and holes from the fourth conductive semiconductor layer 25 may be provided to the active layer 19. The electrons and holes supplied from the first semiconductor layer 15 and the fourth conductive semiconductor layers 25 are recombined with each other in the active layer 19, thereby generating an ultraviolet light having wavelength corresponding to a band gap determined by a material of the active layer 19, for example, wavelength in the range of 270 nm to 290 nm.

Meanwhile, when the fourth conductive semiconductor layer 25 performs both functions of the electrode layer and the barrier layer, the third conductive semiconductor layer 23 may not be formed.

When the third conductive semiconductor layer 23 is not formed, the fourth conductive semiconductor layer 25 may make contact with a top surface of the second conductive semiconductor layer 21.

In the first embodiment, to prevent the ultraviolet light from the active layer 19 from being absorbed by the fourth conductive semiconductor layer 25, the second conductive semiconductor layer 21 capable of reflecting the ultraviolet light may be formed between the active layer 19 and the fourth conductive semiconductor layer 25.

FIG. 4 is a sectional view illustrating a flip chip ultraviolet semiconductor light emitting device as one application example of the ultraviolet semiconductor light emitting device of FIG. 1.

As shown in FIG. 4, for example, the ultraviolet semiconductor light emitting device 100 of the first embodiment may be applied as a flip type ultraviolet semiconductor light emitting device, but the embodiment is not limited thereto.

The flip type ultraviolet semiconductor light emitting device may have a turnover structure of the type ultraviolet semiconductor light emitting device 10.

That is, the buffer layer 13 may be formed below the substrate 11, the first conductive semiconductor layer 15 may be formed below the buffer layer 13, and the active layer 19 may be formed below the first conductive semiconductor layer 15. The second conductive semiconductor layer 21 may be formed below the active layer 19, third conductive semiconductor layer 23 may be formed below the second conductive semiconductor layer 21, and the fourth conductive semiconductor layer 25 may be formed below the third conductive semiconductor layer 23.

Since the flip type ultraviolet semiconductor light emitting device emits the ultraviolet light laterally or upward, a reflective layer 43 may be formed below the fourth conductive semiconductor layer 25 to prevent the ultraviolet light emitted from the active layer 19 from being travelled downward,.

The reflective layer 43 may include a metallic material. For example, the metallic material may include one selected from the group consisting of Ag, Ni, Al, Rh, Pd, Ir, Ru, Mg, Zn, Pt, Au, and Hf, and an alloy thereof.

Before or after forming the reflective layer 43, the fourth conductive semiconductor layer 25, the third conductive semiconductor layer 23, the second conductive semiconductor layer 21, and the active layer 19 may be are mesa-etched so that the first conductive semiconductor layer 15 is partially exposed. A surface of the first conductive semiconductor layer 15 may be partially etched through a mesa etching process.

A first electrode 41 may be provided below the first conductive semiconductor 15 exposed through the mesa etching, and a second electrode 45 may be provided below the reflective layer 43 or the fourth conductive semiconductor layer 25.

A top surface of the second conductive semiconductor layer 19 may be disposed at a location lower than a top surface of the first electrode 41, but the embodiment is not limited thereto.

The second conductive semiconductor layer 19 may horizontally overlap with at least a part of the first electrode 41, but the embodiment is not limited thereto.

Meanwhile, as described above, the second conductive semiconductor layer 21 may function as a reflective layer capable of reflecting the ultraviolet light. If the second conductive semiconductor layer 21 may reflect the ultraviolet light of the active layer 19 upward, the reflective layer 43 may not be formed below the fourth conductive semiconductor layer 25. In this case, a transparent conductive layer instead of the reflective layer 43 may be formed below the fourth conductive semiconductor layer 25, and the second electrode 45 may be provided below the transparent conductive layer, but the embodiment is not limited thereto. Since the transparent conductive layer may serve as a current spreading layer, the transparent conductive layer has the size at least corresponding to the size of the active layer, but the embodiment is not limited thereto. For example, the transparent conductive layer may include at least one selected from the group consisting of ITO, IZO(In-ZnO), GZO(Ga-ZnO), AZO(Al-ZnO), AGZO(Al-Ga ZnO), IGZO(In-Ga ZnO), IrOx, RuOx, RuOx/ITO, Ni/IrOx/Au, and Ni/IrOx/Au/ITO, but the embodiment is not limited thereto.

Light generated from the active layer 19 and travelled downward is reflected from the second conductive semiconductor layer 21 and the reflected light is travelled upward or laterally so that external quantum efficiency may be improved.

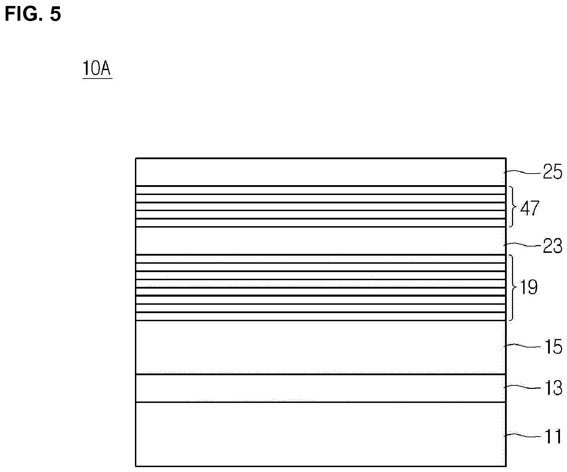

FIG. 5 is a sectional view illustrating an ultraviolet semiconductor light emitting device according to a second illustrative embodiment not forming part of the invention.

The second embodiment is substantially the same as the first embodiment except that a second conductive semiconductor layer 47 is formed between a third conductive semiconductor layer 23 and a fourth conductive semiconductor layer 25.

Like or the same elements in the second embodiment are designated by like or the same numerals are used in the first embodiment, and a detailed description thereof is omitted.

Referring to FIG. 5, the ultraviolet semiconductor light emitting device 10A according to the second embodiment may include a substrate 11, a buffer layer 13, a first conductive semiconductor layer 15, an active layer 19, a second conductive semiconductor layer 47, a third conductive semiconductor layer 23, and a fourth conductive semiconductor layer 25.

The second conductive semiconductor layer 47 may be or not formed on the active layer 19, but the embodiment is not limited thereto.

The second conductive semiconductor layer 47 may be formed on the third conductive semiconductor layer 23 and the fourth conductive semiconductor layer 25 may be formed on the second conductive semiconductor layer 47.

That is, the second conductive semiconductor layer 47 may be formed between the third conductive semiconductor layer 23 and the fourth conductive semiconductor 25.

The ultraviolet light generated from the active layer 19 may be travelled in all directions. A part of the ultraviolet light may be travelled to the second conductive semiconductor layer 47 via the third conductive semiconductor layer 23.

The ultraviolet light travelled to the second conductive semiconductor layer 47 is blocked by the second conductive semiconductor layer 47 so that the ultraviolet light is not travelled to the fourth conductive semiconductor layer 25 including GaN capable of absorbing the ultraviolet light. Thus, deterioration of the external quantum efficiency caused by the absorption of the ultraviolet light by the fourth conductive semiconductor layer 25 may be prevented.

The second conductive semiconductor layer 47 may reflect the ultraviolet light passing through the third conductive semiconductor layer 23 such that the ultraviolet light can be travelled again to the active layer 19 or the first conductive semiconductor layer 15.

Accordingly, the ultraviolet light passing through the third conductive semiconductor layer 23 is blocked by the second conductive semiconductor layer 47 and is reflected from the second conductive semiconductor 47 so that the external quantum efficiency may be improved.

Meanwhile, as a combination of the first and second embodiments, the second conductive semiconductor layer 47 may be formed between the active 19 and the third conductive semiconductor layer 23 and between the third conductive semiconductor layer 23 and the fourth conductive semiconductor layer 25. As described above, since the second conductive semiconductor layer 47 having a reflective function is formed at at least two regions, the light generated from the active layer 19 is prevented from being travelled to the fourth conductive semiconductor layer 25 to minimize optical loss so that the external quantum efficiency may be maximized.

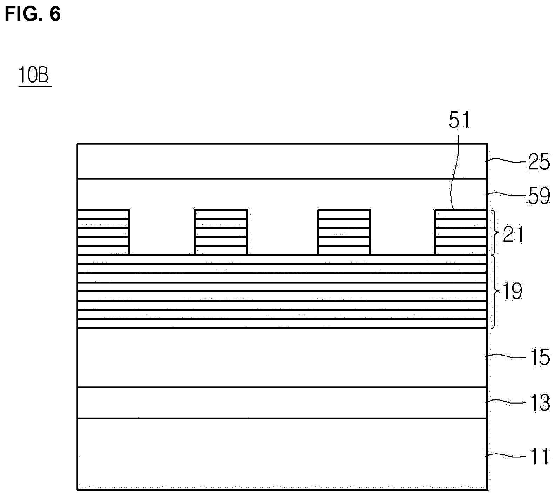

FIG. 6 is a sectional view illustrating an ultraviolet semiconductor light emitting device according to a third embodiment forming part of the invention.

Referring to FIG. 6, in the ultraviolet semiconductor light emitting device 10B according to the third embodiment, the second conductive semiconductor layer 21 on the active layer 19 includes a plurality of patterns 51. Each of the patterns 51 includes a plurality of pair layers 53 and 55 in which the first layers 53a, 55a, and 57a and the second layers 53b and 55b are paired.

The first layers 53a, 55a, and 57a and the second layers 53b and 55b may be understood from the first embodiment, and thus a detailed description thereof is omitted.

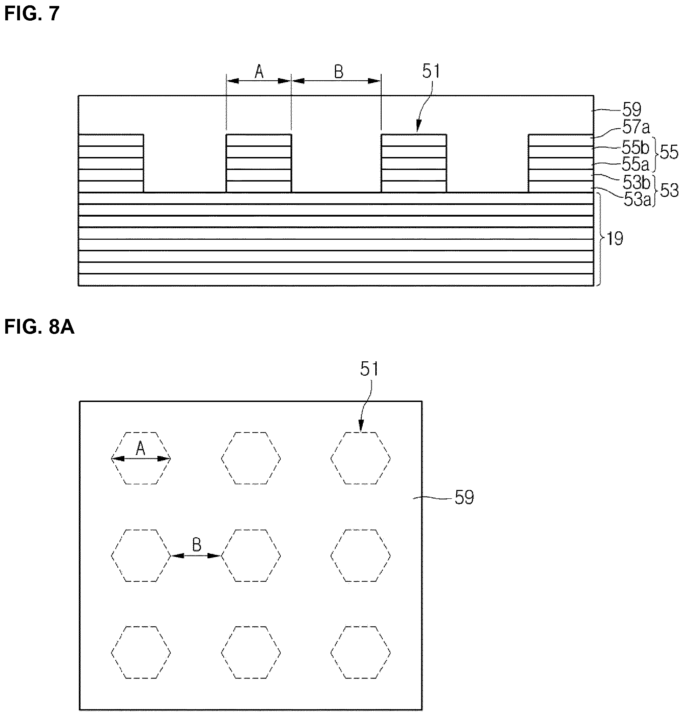

The patterns 51 may have a polygonal shape including a triangular shape, a square shape, a pentagonal shape, and a hexagonal shape (FIG. 8A), but the embodiment is not limited thereto.

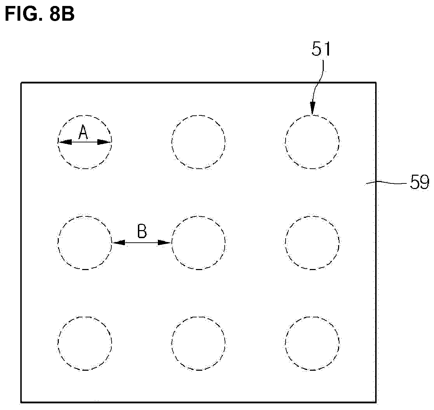

The patterns 51 may has a circular shape (FIG. 8B) or a cylindrical shape, but the embodiment is not limited thereto.

The patterns 51 may be uniformly or randomly disposed.

According to the invention, a side of the pattern 51 is inclined with respect to a horizontal line, for example, a top surface of the active layer 19.

A width of the pattern 51 is gradually reduced upward. That is, among the first layers 53a, 55a, and 57a and the second layers 53b and 55b, widths of layers located at an upper position are smaller than widths of layers located at a lower position.

To the contrary, not forming part for the invention, a width of the pattern 51 may become gradually increased upward. That is, among the first layers 53a, 55a, and 57a and the second layers 53b and 55b, the widths of layers located at the upper position may be larger than the widths of layers located at the lower position.

Not forming part of the invention, the side of the pattern 51 may be perpendicular to the top surface of the active layer 19, but the embodiment is not limited thereto. In the case, the widths of the layers 53a, 53b, 55a, 55b, 57a may be the same as each other.

FIG. 7 is a sectional view illustrating a detailed configuration of a second conductive semiconductor layer of FIG. 6.

According to the invention, as shown in FIG. 7, an interval B between the patterns 51 is larger than a width A of the pattern 51.

The width A of the pattern 51 may be in the range of 0.5 µm to 1 µm, and the interval B of the patterns 51 may be in the range of 1 µm to 2 µm.

The third conductive semiconductor layer 59 may be formed on the top surface of the active layer 19 between the patterns 51 of the second conductive semiconductor layer 21 and top surfaces of the patterns.

The third conductive semiconductor layer 59 may make contact with the top surface of the active layer 19 between the patterns 51 and be formed on sides and top surfaces of the pattern 51.

During a growth process, the third conductive semiconductor layer 59 may be grown from the top surface of the active layer 19 between the patterns 51. The third conductive semiconductor layer 59 may be grown from the top surfaces of the patterns 51 as well as in a space between the patterns 51.

The third conductive semiconductor layer 59 and the active layer 19, for example, barrier layers in a multi-quantum well structure may include the same group III-V or group II-VI compound semiconductor material. For example, a barrier layer of the active layer 19 and the third conductive semiconductor layer 59 may include AlGaN in common, but the embodiment is not limited thereto.

Since barrier layers of the third conductive semiconductor layer 59 and the active layer 19 may include the same group III-V or group II-VI compound semiconductor material, the third conductive semiconductor layer 59 may be stably grown without crack from the active layer 19 between the patterns 51 of the second conductive semiconductor layer 21.

In the third embodiment, since holes of the fourth conductive semiconductor layer 25 may be provided to the active layer 19 through the third conductive semiconductor layer 59 between the patterns 51 of the second conductive semiconductor layer 21 without passing through the patterns 51 of the second conductive semiconductor layer 21, light efficiency may be improved caused by improvement in current injection efficiency.

According to the invention, the second conductive semiconductor layer 21 includes a plurality of patterns 51 to further improve reflective efficiency of the ultraviolet light.

When the fourth conductive layer 25 functions as both of an electrode layer and a barrier layer, the third conductive semiconductor layer 59 may not be formed.

When the third conductive semiconductor layer 59 is not formed, the fourth conductive semiconductor layer 25 may make contact with top surfaces of the patterns 51 of the second conductive semiconductor layer 21 and a top surface of the active layer 19 between the patterns 51 of the second conductive semiconductor layer 21.

The third embodiment may be associated with the first embodiment. That is, the third embodiment may be prepared by forming the second conductive semiconductor layer 21 of the first embodiment including a plurality of patterns 51.

Although not shown, a second conductive semiconductor layer having a plurality of patterns is applicable to the second embodiment not forming part of the invention. That is, the second conductive semiconductor layer 47 of the second embodiment has a plurality of patterns, and the fourth conductive semiconductor layer 25 may make contact with a top surface of the third conductive semiconductor layer 23 between the patterns and top surfaces of the patterns, but the embodiment is not limited thereto.

According to the embodiment, not forming part of the invention, the second conductive semiconductor layer functioning as a reflective layer is formed between the active layer and the fourth conductive semiconductor layer, so that the ultraviolet light of the active layer is reflected from the second conductive semiconductor layer, thereby maximizing the external quantum efficiency.

According to the embodiment, not forming part of the invention, since holes of the fourth conductive semiconductor layer may be provided to the active layer via the third conductive semiconductor layer between the patterns of the second conductive semiconductor layer without passing through the patterns of the second conductive semiconductor layer according to the second conductive semiconductor layer, current spreading effect may be improved.

According to the embodiment of the invention, the second conductive semiconductor layer has a plurality of patterns so that the reflective efficiency of the ultraviolet light may be further improved due to the patterns.

Meanwhile, the ultraviolet semiconductor light emitting devices 10, 10A, and 10B according to the embodiments may be fabricated as a package using a molding member including a fluorescent material or a lighting system with the package.

To use the light emitting devices 10, 10A, and 10B as the lighting system, the ultraviolet light thereof must be converted to visible light.

The invention is not limited by the embodiments, but is defined solely by the appended claims.

Although embodiments have been this disclosure, it should be understood that numerous other modifications and embodiments can be devised by those skilled in the art that will fall within the scope of the invention as defined by the appended claims. More particularly, various variations and modifications are possible in the component parts and/or arrangements of the subject combination arrangement within the scope of the appended claims. In addition to variations and modifications in the component parts and/or arrangements, alternative uses will also be apparent to those skilled in the art.

## Claims

1. An ultraviolet light emitting device (10) comprising:
a first conductive semiconductor layer (15);
an active layer (19) under the first conductive semiconductor layer (15); and
a second conductive semiconductor layer (21) under the active layer (19), wherein the second conductive semiconductor layer (21) comprises a plurality of patterns (51) to form a protrusion,
wherein the plurality of patterns (51) is spaced from each other in a first direction and a second direction crossing the first direction,
**characterized in that** a distance (B) between the plurality of patterns (51) is larger than a width (A) of the plurality of patterns (51), and
width of the patterns (51) reduces in a direction away from the active layer (19),
wherein the plurality of patterns (51) reflects an ultraviolet light emitted from the active layer (19),
wherein the patterns (51) comprises a plurality of compound semiconductor layers (31a, 31b, 33a, 33b, 35a) comprising at least two semiconductor materials, and
wherein the contents of the at least two semiconductor materials are different from each other.

2. The ultraviolet light emitting device (10) according to claim 1, wherein the width (A) of the patterns (51) is in the range of 0.5 µm to 1 µm and the distance (B) of the patterns (51) is in the range of 1 µm to 2 µm.

3. The ultraviolet light emitting device (10) according to claim 1, wherein the patterns (51) comprises one of a polygonal shape, a circular shape and a cylindrical shape.

4. The ultraviolet light emitting device (10) according to claim 1, further comprising a third conductive semiconductor layer (59) including a p type dopant under the second conductive semiconductor layer (21),
wherein the third conductive semiconductor layer (59) is directly in contact with the active layer (19) between the patterns (51),
and the first conductive semiconductor layer (15) includes an n type dopant.

5. The ultraviolet light emitting device (10) according to claim 4, further comprising: a fourth conductive semiconductor layer (25) under the third conductive semiconductor layer (59).

6. The ultraviolet light emitting device (10) according to claim 1, wherein a lowermost layer and an uppermost layer of the patterns (51) comprises at least two semiconductor layers (31a, 35a) having the same contents.

7. The ultraviolet light emitting device (10) according to claim 1, wherein an uppermost layer (31a) of the patterns (51) is a lowermost layer of the active layer (19).

8. The ultraviolet light emitting device (10) according to claim 1, wherein an uppermost layer (31a) of the patterns (51) is a barrier layer of the active layer (19).

9. The ultraviolet light emitting device (10) according to claim 5, further comprising: a first electrode (41) under the first conductive semiconductor layer (15); and a second electrode (45) under one layer of the third conductive semiconductor layer (59) and the fourth conductive semiconductor layer (25).

10. The ultraviolet light emitting device (10) according to claim 1, wherein each of the plurality of patterns (51) has a hexagonal shape.

## Patentansprüche

1. Ultraviolettes Licht emittierende Vorrichtung (10), umfassend:
eine erste leitfähige Halbleiterschicht (15);
eine aktive Schicht (19) unter der ersten leitfähigen Halbleiterschicht (15); und
eine zweite leitfähige Halbleiterschicht (21) unter der aktiven Schicht (19), wobei die zweite leitfähige Halbleiterschicht (21) eine Mehrzahl von Strukturen (51) umfasst, um einen Vorsprung zu bilden,
wobei die Mehrzahl von Strukturen (51) in einer ersten Richtung und einer die erste Richtung kreuzenden zweiten Richtung voneinander beabstandet ist,
**dadurch gekennzeichnet, dass** ein Abstand (B) zwischen der Mehrzahl von Strukturen (51) größer als eine Breite (A) der Mehrzahl von Strukturen (51) ist, und
sich eine Breite der Strukturen (51) in einer Richtung weg von der aktiven Schicht (19) verringert,
wobei die Mehrzahl von Strukturen (51) ein von der aktiven Schicht (19) emittiertes ultraviolettes Licht reflektiert,
wobei die Strukturen (51) eine Mehrzahl von Verbundhalbleiterschichten (31a, 31b, 33a, 33b, 35a) umfassen, welche wenigstens zwei Halbleitermaterialien umfassen, und
wobei sich die Inhalte der wenigstens zwei Halbleitermaterialien voneinander unterscheiden.

2. Ultraviolettes Licht emittierende Vorrichtung (10) nach Anspruch 1, wobei die Breite (A) der Strukturen (51) in dem Bereich von 0,5 µm bis 1 µm liegt und der Abstand (B) der Strukturen (51) in dem Bereich von 1 µm bis 2 µm liegt.

3. Ultraviolettes Licht emittierende Vorrichtung (10) nach Anspruch 1, wobei die Strukturen (51) eine polygonale Form, eine kreisförmige Form und eine zylindrische Form umfassen.

4. Ultraviolettes Licht emittierende Vorrichtung (10) nach Anspruch 1, ferner umfassend eine dritte leitfähige Halbleiterschicht (59), welche einen Dotierstoff vom p-Typ umfasst, unter der zweiten leitfähigen Halbleiterschicht (21),
wobei die dritte leitfähige Halbleiterschicht (59) zwischen den Strukturen (51) direkt mit der aktiven Schicht (19) in Kontakt ist
und die erste leitfähige Halbleiterschicht (15) einen Dotierstoff vom n-Typ umfasst.

5. Ultraviolettes Licht emittierende Vorrichtung (10) nach Anspruch 4, ferner umfassend: eine vierte leitfähige Halbleiterschicht (25) unter der dritten leitfähigen Halbleiterschicht (59).

6. Ultraviolettes Licht emittierende Vorrichtung (10) nach Anspruch 1, wobei eine unterste Schicht und eine oberste Schicht der Strukturen (51) wenigstens zwei Halbleiterschichten (31a, 35a) umfassen, welche die gleichen Inhalte aufweisen.

7. Ultraviolettes Licht emittierende Vorrichtung (10) nach Anspruch 1, wobei eine oberste Schicht (31a) der Strukturen (51) eine unterste Schicht der aktiven Schicht (19) ist.

8. Ultraviolettes Licht emittierende Vorrichtung (10) nach Anspruch 1, wobei eine oberste Schicht (31a) der Strukturen (51) eine Barriereschicht der aktiven Schicht (19) ist.

9. Ultraviolettes Licht emittierende Vorrichtung (10) nach Anspruch 5, ferner umfassend: eine erste Elektrode (41) unter der ersten leitfähigen Halbleiterschicht (15); und eine zweite Elektrode (45) unter einer Schicht der dritten leitfähigen Halbleiterschicht (59) und der vierten leitfähigen Halbleiterschicht (25).

10. Ultraviolettes Licht emittierende Vorrichtung (10) nach Anspruch 1, wobei jede der Mehrzahl von Strukturen (51) eine hexagonale Form aufweist.

## Revendications

1. Dispositif luminescent ultraviolet (10) comprenant :
une première couche conductrice de semiconducteur (15) ;
une couche active (19) sous la première couche conductrice de semiconducteur (15) ;
et
une deuxième couche conductrice de semiconducteur (21) sous la couche active (19), la deuxième couche conductrice de semiconducteur (21) comprenant une pluralité de motifs (51) pour former une saillie,
dans lequel la pluralité de motifs (51) sont espacés les uns des autres dans une première direction et une seconde direction croisant la première direction,
**caractérisé en ce qu'**une distance (B) entre la pluralité de motifs (51) est supérieure à une largeur (A) de la pluralité de motifs (51), et
la largeur des motifs (51) diminue en s'éloignant de la couche active (19),
dans lequel la pluralité de motifs (51) réfléchit la lumière ultraviolet émise par la couche active (19),
dans lequel les motifs (51) comprennent une pluralité de couches de semi-conducteur composé (31a, 31b, 33a, 33b, 35a) comprenant au moins deux matériaux semi-conducteurs, et
dans lequel les contenus des au moins deux matériaux semi-conducteurs sont différents l'un de l'autre.

2. Dispositif luminescent ultraviolet (10) selon la revendication 1, dans lequel la largeur (A) des motifs (51) est dans la plage de 0,5 µm à 1 µm et la distance (B) des motifs (51) est dans la plage de 1 µm à 2 µm.

3. Dispositif luminescent ultraviolet (10) selon la revendication 1, dans lequel les motifs (51) comprennent une forme parmi une forme polygonale, une forme circulaire et une forme cylindrique.

4. Dispositif luminescent ultraviolet (10) selon la revendication 1, comprenant en outre une troisième couche conductrice de semiconducteur (59) comportant un dopant de type p sous la deuxième couche conductrice de semiconducteur (21),
dans lequel la troisième couche conductrice de semiconducteur (59) est directement en contact avec la couche active (19) entre les motifs (51),
et la première couche conductrice de semiconducteur (15) comporte un dopant de type n.

5. Dispositif luminescent ultraviolet (10) selon la revendication 4, comprenant en outre :
une quatrième couche conductrice de semiconducteur (25) sous la troisième couche conductrice de semiconducteur (59).

6. Dispositif luminescent ultraviolet (10) selon la revendication 1, dans lequel une couche la plus basse et une couche la plus haute des motifs (51) comprennent au moins deux couches de semiconducteur (31a, 35a) ayant le même contenu.

7. Dispositif luminescent ultraviolet (10) selon la revendication 1, dans lequel une couche la plus haute (31a) des motifs (51) est une couche la plus basse de la couche active (19).

8. Dispositif luminescent ultraviolet (10) selon la revendication 1, dans lequel une couche la plus haute (31a) des motifs (51) est une couche barrière de la couche active (19).

9. Dispositif luminescent ultraviolet (10) selon la revendication 5, comprenant en outre :
une première électrode (41) sous la première couche conductrice de semiconducteur (15) ; et
une seconde électrode (45) sous une couche parmi la troisième couche conductrice de semiconducteur (59) et la quatrième couche conductrice de semiconducteur (25).

10. Dispositif luminescent ultraviolet (10) selon la revendication 1, dans lequel chaque motif parmi la pluralité de motifs (51) a une forme hexagonale.
